# EUROPEAN PATENT SPECIFICATION

(11) **EP 1 380 899 B1**
(45) Date of publication and mention of the grant of the patent: **03.09.2014**
(21) Application number: 03254358.9
(22) Date of filing: 09.07.2003
(51) Int. Cl.: G03F 7/20

(54) **Lithographic apparatus and device manufacturing method**
Lithographischer Apparat und Verfahren zur Herstellung einer Vorrichtung
Appareil lithographique et méthode de fabrication d'un dispositif

(30) Priority: 11.07.2002 EP 02254863
(43) Date of publication of application: 14.01.2004
(73) Proprietor: ASML Netherlands B.V., 5504 DR Veldhoven (NL)
(72) Inventor: Franken, Dominicus Jacobus Petrus Adrianus, 5508 JA Veldhoven (NL); Loopstra, Erik Roelof, 5591 BA Heeze (NL); Bartray, Pertrus Rutgerus, 5813 BR IJsselsteijn (NL); Van der Wijst, Mark Wilhelmus Maria, 5501 JB Veldhoven (NL); Renkens, Michael Jozefa Mathijs, 6135 HC Sittard (NL); Van Schothorst, Gerard, 5321 VR Hedel (NL); Dries, Johan Juliana, 2370 Aerendonk (BE)
(74) Representative: Slenders, Petrus J. W.

(56) References cited:
- EP-A- 1 081 521
- EP-A- 1 220 037
- EP-A- 1 237 044
- US-A- 5 508 518

## Description

The present invention relates to a lithographic projection apparatus comprising:
- a radiation system for providing a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate,
- a base to which said support structure and said substrate table are mounted;
- a reference frame, compliantly mounted to said base.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096. In the case of a programmable mirror array, the said support structure may be embodied as a frame or table, for example, which may be fixed or movable as required.
- A programmable LCD array. An example of such a construction is given in United States Patent US 5,229,872. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus― commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791.

In order to accurately expose the substrate, the projection system must be mounted on the apparatus in such a manner that any vibrations or displacements within the apparatus do not affect the position of the elements within the projection system. This is critical since the projection system contains many optical elements connected to a projection frame which must be accurately positioned relative to one another and relative to other components in the apparatus. Displacements and vibrations of the projection frame may cause so-called rigid body errors in which the projection frame as a whole is displaced and the optical elements within it are displaced relative to other components in the apparatus.

In addition the vibrations and distortions of the projection frame may cause flexure and/or strains in the projection frame which reduce the accuracy of the relative positions of the elements mounted on the projection frame. Both sources of positional inaccuracy of the optical elements (relative to the remainder of the apparatus and relative to the other elements) reduce the accuracy of the projection of the image onto the substrate.

It has therefore been previously known to rigidly mount the projection frame onto a reference frame which is compliantly mounted on the base of the apparatus. Such a reference frame is used to support components of the apparatus, such as position sensors, that are sensitive to vibrations. By compliantly mounting, or "soft-mounting", the reference frame on the base, vibrations and displacements acting on the base (which may be caused by, for example, reaction forces from actuators positioning other components of the apparatus) will be low-pass filtered by the mounts and the disturbance on the reference frame, and hence the projection frame and the optical elements, is reduced. However, as the critical dimension of devices produced using the lithography process decreases, the required accuracy of the apparatus increases. Therefore, the continuing increase in demand for smaller device dimensions means that the tolerable position error within the projection optics is reduced. In order to allow for this reduction, the soft-mount for the reference frame must be improved to reduce the vibration transmitted from the base of the apparatus to the reference frame. In conventional lithographic apparatus the soft-mounts may be so-called "air-mounts" in which the reference frame is supported on an air cushion of some restricted volume. In order to improve such an air-mount to meet the requirements for the maximum vibration being passed to the projection optics, the air-mounts supporting the reference frame must be increased in size. However the space available around the lithographic projection apparatus is limited and, therefore, when the required performance for the mounts (driven by the dimension of the devices to be formed on the substrate) reaches a given value, the conventional means of supporting the projection frame are no longer appropriate.

Furthermore, even where the reference frame is sufficiently isolated from the base, additional vibrations may be introduced to the reference frame by, for example, water cooling tubes.

EP 1 220 037 discloses a lithography apparatus having a main body frame comprising a first member placed on a base member via a vibration proof member; first and second stages are supported by the first member; the projection system is held by a second member, placed on the first member via a second vibration proof member.

It is an object of the present invention to provide a lithographic apparatus in which the projection frame is supported in such a manner that the vibration and positional errors transmitted to it are less than those in the conventional device.

This and other objects are achieved according to the invention in a lithographic apparatus according to claim 1.

The projection frame is mounted on the reference frame using compliant mounts that are attached to the reference frame on the nodal axes of the dominant mode of bending vibration or torsional vibration of the reference frame.

This is advantageous since the strict limits to the vibration transmitted to the projection system can be achieved using mounts for the reference frame which are not larger than conventional mounts. The apparatus is further advantageous in that other elements of the lithographic apparatus, which do not need this level of positional accuracy, may be mounted to the reference frame in the conventional manner.

This is also beneficial since such bending or torsional vibration of the reference frame produces the greatest distortion of the reference frame but, by mounting it in this fashion, very little of this distortion will be transmitted to the projection frame.

Preferably, the Eigenfrequency of the mounting of the projection frame on the reference frame is between about 10 and 30 Hz and the Eigenfrequency of the mounting of the reference frame on the base is about 0.5 Hz. This apparatus is extremely beneficial since it result in very low levels of vibration being transmitted from the base to the projection system but the size of the mounts for the reference frame will still be within practical limits.

Advantageously, the motion of the projection frame relative to the reference frame may be damped. This reduces the displacement of the projection frame relative to the reference frame at the low frequencies around the resonant frequency of the mounting.

In one embodiment the compliant mounts used to mount the projection frame onto the reference frame are at least one of an air-mount, a spring and a magnetic support. These mounts are advantageous since their responses are well known and understood.

According to an alternative embodiment, the compliant mounts are formed from a T-shaped member with one of the projection frame and reference frame attached to both ends of the cross-piece and the other attached to the end of the leg. This compliant mount is advantageous since it requires very little maintenance, can easily be replaced and may be simply tuned by adjusting the lengths and widths of the cross-piece and leg members.

According to a further preferred embodiment, the T-shaped member has an internal first eigenfrequency that is greater than 1000 Hz. In this way vibrational problems related to the suspension of the projection system can be successfully avoided.

According to a further aspect of the invention there is provided a device manufacturing method according to claim 10.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range 5-20 nm), as well as particle beams, such as ion beams or electron beams.

Embodiments of the invention will now be described, by way of example only, with reference to the accompanying schematic drawings in which:
Figure 1 depicts a lithographic projection apparatus according to an embodiment of the invention;
Figure 2 depicts a projection system mounted to an isolated reference frame by means of compliant supports;
Figure 3 depicts a projection system of the type used in the present invention;
Figure 4 depicts a reference frame of the present invention showing the mounting positions for mounting the projection system according to the present invention;
Figure 5 depicts the reference frame of the present invention showing the mounting points for mounting the projection system according to an alternative embodiment of the present invention; and
Figure 6 depicts a compliant mount for supporting the projection system according to an embodiment of the present invention.

In the Figures, corresponding reference symbols indicate corresponding parts.

### Embodiment 1

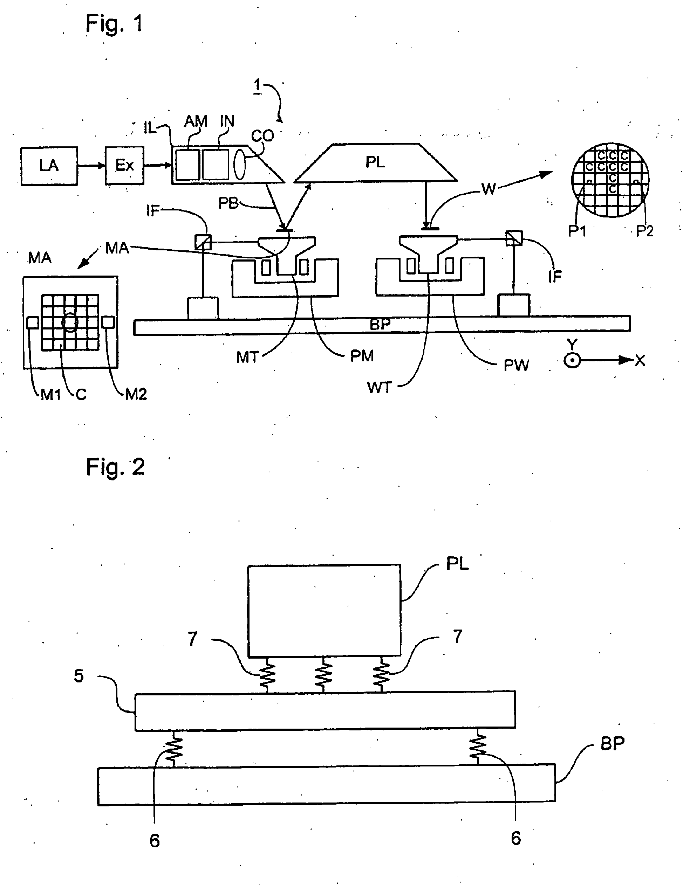

Figure 1 schematically depicts a lithographic projection apparatus according to a particular embodiment of the invention. The apparatus comprises:
- a radiation system Ex, IL, for supplying a projection beam PB of radiation (*e.g*. EUV radiation), which in this particular case also comprises a radiation source LA;
- a first object table (mask table) MT provided with a mask holder for holding a mask MA (*e.g*. a reticle), and connected to first positioning means for accurately positioning the mask with respect to item PL;
- a second object table (substrate table) WT provided with a substrate holder for holding a substrate W (*e.g*. a resist-coated silicon wafer), and connected to second positioning means for accurately positioning the substrate with respect to item PL;
- a projection system ("lens") PL (*e.g*. mirror group) for imaging an irradiated portion of the mask MA onto a target portion C (*e.g*. comprising one or more dies) of the substrate W.
As here depicted, the apparatus is of a reflective type (*e.g*. has a reflective mask). However, in general, it may also be of a transmissive type, for example (*e.g*. with a transmissive mask). Alternatively, the apparatus may employ another kind of patterning means, such as a programmable mirror array of a type as referred to above.

The source LA (*e.g.* a laser-produced or discharge plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (*e.g.* with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having been selectively reflected by the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:
1. In step mode, the mask table MT is kept essentially stationary, and an entire mask image is projected in one go *(i.e.* a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g.* the y direction) with a speed *v*, so that the projection beam PB is caused to scan over a mask image; concurrently, the substrate table WT is simultaneously moved in the same or opposite direction at a speed *V = Mv,* in which *M* is the magnification of the lens PL (typically, *M* = 1/4 or 1/5), In this manner, a relatively large target portion C can be exposed, without having to compromise on resolution.

Figure 2 shows the projection system PL mounted to an isolated reference frame 5. The reference frame 5 is, in turn, mounted on the base BP of the apparatus. Compliant mounts 6 are used to support the reference frame 5. These mounts have low-pass characteristics and may have an Eigenfrequency of between about 0.1 Hz and 10 Hz and preferably have an Eigenfrequency of approximately 0.5 Hz. These mounts therefore attenuate the transmission of any vibrations or displacements from the base BP to the reference frame 5. This is important as the vibrations in the base frame BP will be larger than the maximum allowed in the projection system PL. The vibrations in the base frame may be caused by, for example, reaction forces from the actuators used to position the elements of the apparatus. However, despite the use of the mounts 6, the amplitude of the vibrations in the reference frame 5 may be larger than the maximum allowable in the projection system PL. Therefore the projection system PL is mounted to the reference frame 5 by means of compliant supports 7. These supports 7 present low-pass characteristics, having cut-off or Eigenfrequencies of, for example, between about 10 and about 30 Hz. The soft-mounting of the projection system PL on the reference frame 5 therefore further filters the vibration and motion of the base BP.

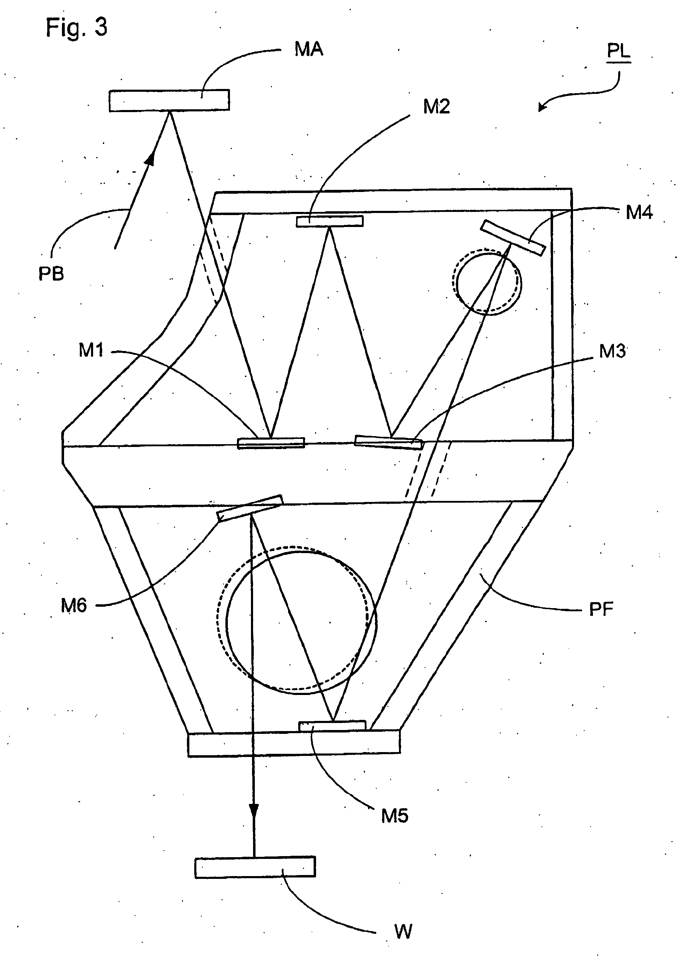

Figure 3 shows a projection system PL that may be used with the present invention. It comprises a projection frame PF, to which are mounted a plurality of optical elements M1, M2, M3, M4, M5, M6. The projection system of the present invention may further comprise a second projection frame (not shown in Figure 2) to which sensors may be attached to monitor the position of the optical elements M1, M2, M3, M4, M5, M6. One or, preferably, both of the projection frames is compliantly mounted on the reference frame. If only one projection frame is to be compliantly mounted on the reference frame, it may be desirable for this to be the second projection frame which then ensures a fully stable frame of reference to monitor the position of the optical elements M1, M2, M3, M4, M5, M6 within the projection system PL. Additionally compliantly mounting the first projection frame on the reference frame prevents force feedback through the reference frame.

The reference frame mounts 6 and the projection system mounts 7 may be any form of so-called soft-mounts. That is to say, the mounts 7 may be any kind of support with low stiffness. For instance, the mounts may be very soft springs, air-mounts (in which one part of the mount is supported relative to the other by a cushion of a volume of gas) or may be magnetic mounts (in which one part of the mount is supported relative to the other by means of a magnetic force).

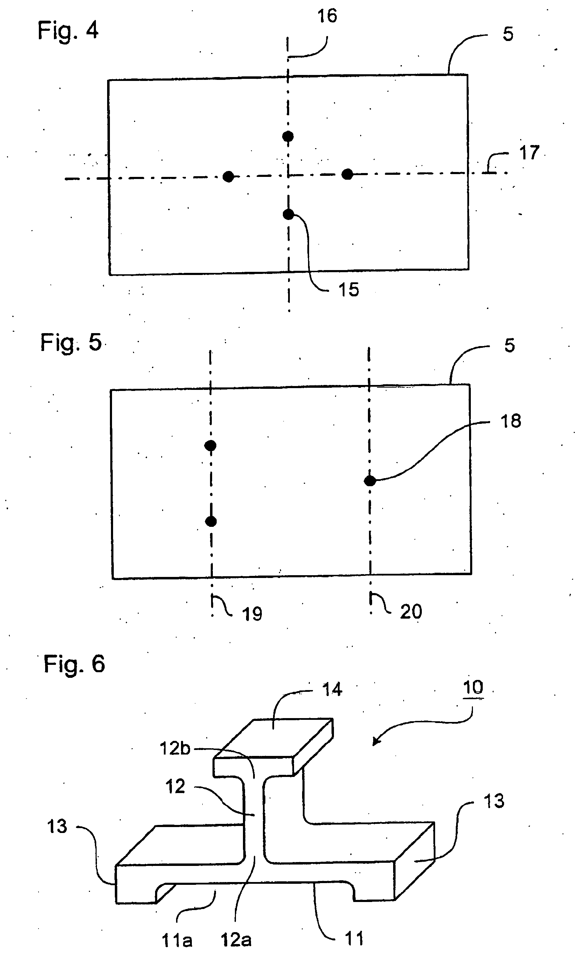

The mounts 6, 7, especially the projection system mounts 7 may, alternatively, be solid mounts. Figure 6 shows a design of such a solid support 10. The solid support is comprised of an elongate member 11 which is attached, by attachment points 13 at either end, to one of the reference frame 5 and the projection frame PF. A second elongate member 12 is connected to the first elongate member 11 at one end 12a and has an attachment point 14 at the other end 12b. The attachment point 14 is used to connect the mount to the other of the reference frame 5 and the projection frame PF. The second elongate member 12 is connected to the first elongate member 11 between the two attachment points 13 on the first elongate member. Consequently, bending and flexure of the first and second elongate members 11, 12 provide relative movement between the attachment points 13 on the first elongate member and the attachment point 14 on the second elongate member. The frequency response of the mount 10 can be selected by using materials with appropriate stiffness and altered by adjusting the width and length of the first and second elongate members 11, 12. The mount may be formed from, for example, high tensile steel or Invar ™ (a cobalt containing steel that has a relatively low coefficient of thermal expansion). In practice it has been found that it is very advantageous if the T-shaped mount 10 has an internal first eigenfrequency that is greater than 1 000 Hz. In particular it has shown to be advantageous if the internal first eigenfrequency of said mount 10 is much larger than 1000 Hz.

As shown in Figure 6, there is a space 11a below the first elongate member 11 and between the two attachment points 13 on the first elongate member 11. A block (not shown) may be provided in this space 11 a to prevent large movements of the first elongate member 11.

Compliantly mounting the projection system PL onto the reference frame 5 may, however, result in displacement errors of the projection system PL relative to the reference frame 5. This will be especially true for vibrations that are close to the Eigenfrequency of the mount. Therefore it may be necessary to provide damping of the motion of the projection system PL relative to the reference frame 5. The damping may be provided within the mounts themselves or may be applied at a different part of the projection frame PF. The damping applied may be passive or may be active using, for example, piezoelectric actuators or Lorentz-force actuators.

The choice of location of the mounts on the reference frame may also aid to reduce the amount of vibration and position error that is transmitted to the projection system PL. Figure 4 shows a possible mounting location 15 for the projection system on the reference frame 5. The reference frame 5 may have torsional modes of vibration in which two axes 16, 17 in the plane of the frame are nodal. That is to say, when the reference frame 5 vibrates purely in this mode, the points on these nodal axes 16, 17 remain substantially motionless. Therefore by attaching the mounts at these locations 15, substantially no vibrations from this mode of vibration are transmitted to the projection system PL.

Figure 5 shows an alternative arrangement in which the mounts are attached at locations 18 on the nodal axes for the dominant bending mode of vibration for the reference frame 5. Again, when the reference frame 5 vibrates predominantly in this mode, the nodal axes 19, 20 are substantially motionless and therefore vibrations in this mode are not transmitted to the projection system PL. The projection system is mounted according to the configuration shown in Figure 4 or Figure 5, depending on which mode of vibration of the reference frame 5 (torsional or bending) is the most detrimental to the projection system.

In addition to the projection system, other components which are sensitive to vibration and displacement errors may be mounted on the reference frame. In particular, measurement sensors, for determining the position of, for example, the substrate table or the mask holder may be mounted on the reference frame. These components may also be mounted on the nodal axes of the reference frame.

Whilst specific embodiments of the invention have been described above, it will be appreciated that the invention may be practiced otherwise than as described. The description is not intended to limit the invention which is defined by the claims.

## Claims

1. A lithographic projection apparatus comprising:
- a radiation system (LA,Ex,IL) arranged to provide a projection beam of radiation (PB);
- a support structure (MT) arranged to support patterning means (MA), the patterning means serving to pattern the projection beam according to a desired pattern;
- a substrate table (WT) arranged to hold a substrate (W);
- a projection system (PL) arranged to project the patterned beam onto a target portion (C) of the substrate (W),
- a base (BP) to which said support structure (MT) and said substrate table (WT) are mounted;
- a reference frame (5), compliantly mounted to said base (BP); wherein
- the projection system (PL) comprises at least one optical element (M1,M2,M3, M4, M5, M6) and a projection frame (PF) arranged such that the at least one optical element (M1, M2, M3, M4, M5, M6) is mounted on said projection frame (PF),
**characterized in that**:
said projection frame (PF) is compliantly mounted to the reference frame (5) on the nodal axes (19,20) of the dominant mode of bending vibration of the reference frame and/or the nodal axes (16,17) of the dominant mode of torsional vibration of the reference frame.

2. A lithographic protection apparatus according to claim 1, wherein the Eigenfrequency of the projection frame (PL) compliantly mounted to the reference frame (5) is between about 10 and 30 Hz.

3. A lithographic projection apparatus according to claim 1 or 2, wherein the Eigenfrequency of the reference frame (5) compliantly mounted to the base (BP) is about 0.5 Hz.

4. A lithographic projection apparatus according to any one of the preceding claims, wherein the projection system (PL) is compliantly mounted to the reference frame (5) using at least three compliant mounts (7).

5. A lithographic projection apparatus according to any one of the preceding claims, wherein the projection system is compliantly mounted by at least one compliant mount comprising:
- a T-shaped member (10) with one of the projection system (PL) and the reference frame (5) attached to both ends of the cross-piece (11) and the other one attached to the end of the leg (12).

6. A lithographic projection apparatus according to claim 5, wherein the T-shaped member (10) has an internal first eigenfrequency that is greater than 1000 Hz.

7. A lithographic projection apparatus according to any one of the preceding claims, wherein the projection system (PL) is compliantly mounted by at least one compliant mount (7) that is one of an air-mount, a spring and a magnetic support.

8. A lithographic projection apparatus according to any one of the preceding claims, wherein the motion of the projection system (PL) relative to the reference frame (5) is damped.

9. A lithographic projection apparatus according to claim 8, wherein said damping is active damping controlled by piezoelectric actuators or Lorentz-force actuators.

10. A device manufacturing method comprising the steps of:
- providing a substrate (W) that is at least partially covered by a layer of radiation-sensitive material;
- providing a projection beam of radiation (PB) using a radiation system (LA,Ex, IL);
- using patterning means (MA) to endow the projection beam (PB) with a pattern in its cross-section;
- projecting the patterned beam of radiation onto a target portion (C) of the layer of radiation-sensitive material using a projection system (PL);
- supporting a reference frame (5), a support structure (MT) for supporting the patterning means (MA) and a substrate table (WT) for holding the substrate (W) on a base; wherein said reference frame (5) is compliantly mounted to the base (BP) and said projection system (PL) is mounted to said reference frame (5);
- compliantly mounting the projection system (PL) to said reference frame (5) while projecting the patterned beam of radiation onto the target portion (C);
**characterized by**:
said step of compliantly mounting the projection system (PL) to said reference frame (5) is on at least one of the nodal axes (19,20) of the dominant mode of bending vibration of the reference fraine and the nodal axes (16,17) of the dominant mode of torsional vibration of the reference frame.

## Patentansprüche

1. Ein lithographisches Projektionsgerät, das Folgendes beinhaltet:
- ein Strahlungssystem (LA, Ex, IL), das eingerichtet ist, um einen Projektionsstrahl aus Strahlung (PB) bereitzustellen;
- eine Stützstruktur (MT), die eingerichtet ist, um ein Musteraufbringungsmittel (MA) zu stützen, wobei das Musteraufbringungsmittel dazu dient, den Projektionsstrahl gemäß einem gewünschten Muster zu mustern;
- einen Substrattisch (WT), der eingerichtet ist, um ein Substrat (W) zu halten;
- ein Projektionssystem (PL), das eingerichtet ist, um den gemusterten Strahl auf einen Zielabschnitt (C) des Substrats (W) zu projizieren;
- eine Basis (BP), an der die Stützstruktur (MT) und der Substrattisch (WT) montiert sind;
- einen Bezugsrahmen (5), der nachgiebig an der Basis (BP) montiert ist;
wobei
- das Projektionssystem (PL) mindestens ein optisches Element (M1, M2, M3, M4, M5, M6) und einen Projektionsrahmen (PF) beinhaltet, die so eingerichtet sind, dass das mindestens eine optische Element (M1, M2, M3, M4, M5, M6) an dem Projektionsrahmen (PF) montiert ist, der nachgiebig an dem Bezugsrahmen (5) montiert ist, **dadurch gekennzeichnet, dass**:
der Projektionsrahmen (PF) auf den Knotenachsen (19, 20) des Grundtyps der Biegeschwingung des Bezugsrahmens und/oder den Knotenachsen (16, 17) des Grundtyps der Torsionsschwingung des Bezugsrahmens nachgiebig an dem Bezugsrahmen (5) montiert ist.

2. Lithographisches Projektionsgerät gemäß Anspruch 1, wobei die Eigenfrequenz des Projektionsrahmens (PL), der nachgiebig an dem Bezugsrahmen (5) montiert ist, zwischen etwa 10 und 30 Hz liegt.

3. Lithographisches Projektionsgerät gemäß Anspruch 1 oder 2, wobei die Eigenfrequenz des Bezugsrahmens (5), der nachgiebig an der Basis (BP) montiert ist, etwa 0,5 Hz beträgt.

4. Lithographisches Projektionsgerät gemäß einem der vorhergehenden Ansprüche, wobei das Projektionssystem (PL) unter Verwendung von mindestens drei nachgiebigen Haltern (7) nachgiebig an dem Bezugsrahmen (5) montiert ist.

5. Lithographisches Projektionsgerät gemäß einem der vorhergehenden Ansprüche, wobei das Projektionssystem durch mindestens einen nachgiebigen Halter, der Folgendes beinhaltet, nachgiebig montiert ist:
- ein T-förmiges Element (10), wobei eines von dem Projektionssystem (PL) und dem Bezugsrahmen (5) an beiden Enden des Querstücks (11) angebracht ist und das andere an dem Ende des Schenkels (12) angebracht ist.

6. Lithographisches Projektionsgerät gemäß Anspruch 5, wobei das T-förmige Element (10) eine interne erste Eigenfrequenz aufweist, die größer als 1000 Hz ist.

7. Lithographisches Projektionsgerät gemäß einem der vorhergehenden Ansprüche, wobei das Projektionssystem (PL) durch mindestens einen nachgiebigen Halter (7), der eines von einem Lufthalter, einer Feder und einer magnetischen Stütze ist, nachgiebig montiert ist.

8. Lithographisches Projektionsgerät gemäß einem der vorhergehenden Ansprüche, wobei die Bewegung des Projektionssystems (PL) in Bezug auf den Bezugsrahmen (5) gedämpft ist.

9. Lithographisches Projektionsgerät gemäß Anspruch 8, wobei das Dämpfen ein aktives Dämpfen ist, das durch piezoelektrische Aktoren oder Lorentz-Kraft-Aktoren gesteuert wird.

10. Ein Verfahren zum Herstellen einer Vorrichtung, das die folgenden Schritte beinhaltet:
- Bereitstellen eines Substrats (W), das mindestens teilweise mit einer Schicht aus strahlungsempfindlichem Material überzogen ist;
- Bereitstellen eines Projektionsstrahls aus Strahlung (PB) unter Verwendung eines Strahlungssystems (LA, Ex, IL);
- Verwenden eines Musteraufbringungsmittels (MA), um den Projektionsstrahl (PB) in seinem Querschnitt mit einem Muster zu versehen;
- Projizieren des gemusterten Strahls aus Strahlung auf einen Zielabschnitt (C) der Schicht aus strahlungsempfindlichem Material unter Verwendung eines Projektionssystems (PL);
- Stützen eines Bezugsrahmens (5), einer Stützstruktur (MT) zum Stützen des Musteraufbringungsmittels (MA) und eines Substrattisches (WT) zum Halten des Substrats (W) auf einer Basis; wobei der Bezugsrahmen (5) nachgiebig an der Basis (BP) montiert ist und das Projektionssystem (PL) an dem Bezugsrahmen (5) montiert ist;
- nachgiebiges Montieren des Projektionssystems (PL) an dem Bezugsrahmen (5) während des Projizierens des gemusterten Strahls aus Strahlung auf den Zielabschnitt (C);
**dadurch gekennzeichnet, dass**
der Schritt des nachgiebigen Montierens des Projektionssystems (PL) an dem Bezugsrahmen (5) auf mindestens einer der Knotenachsen (19, 20) des Grundtyps der Biegeschwingung des Bezugsrahmens und der Knotenachsen (16, 17) des Grundtyps der Torsionsschwingung des Bezugsrahmens geschieht.

## Revendications

1. Un appareil de projection lithographique comprenant :
- un système de rayonnement (LA, Ex, IL) agencé pour fournir un faisceau de projection de rayonnement (PB) ;
- une structure formant support (MT) agencée pour supporter un moyen pour conformer selon un motif (MA), le moyen pour conformer selon un motif servant à conformer le faisceau de projection selon un motif souhaité ;
- une table porte-substrat (WT) agencée pour porter un substrat (W) ;
- un système de projection (PL) agencé pour projeter le faisceau à motif sur une portion cible (C) du substrat (W),
- une base (BP) sur laquelle sont montées ladite structure formant support (MT) et ladite table porte-substrat (WT) ;
- un cadre de référence (5), monté de manière souple sur ladite base (BP) ;
dans lequel
- le système de projection (PL) comprend au moins un élément optique (M1, M2, M3, M4, M5, M6) et un cadre de projection (PF) agencés de telle sorte que l'au moins un élément optique (M1, M2, M3, M4, M5, M6) soit monté sur ledit cadre de projection (PF) qui est monté de manière souple sur le cadre de référence (5), **caractérisé en ce que** :
ledit cadre de projection (PF) est monté de manière souple sur le cadre de référence (5) sur les axes nodaux (19, 20) du mode dominant de vibration de flexion du cadre de référence et/ou les axes nodaux (16, 17) du mode dominant de vibration de torsion du cadre de référence.

2. Un appareil de projection lithographique selon la revendication 1, dans lequel la fréquence propre du cadre de projection (PL) monté de manière souple sur le cadre de référence (5) se situe entre environ 10 et 30 Hz.

3. Un appareil de projection lithographique selon la revendication 1 ou la revendication 2, dans lequel la fréquence propre du cadre de référence (5) monté de manière souple sur la base (BP) se situe aux environs de 0,5 Hz.

4. Un appareil de projection lithographique selon l'une quelconque des revendications précédentes, dans lequel le système de projection (PL) est monté de manière souple sur le cadre de référence (5) à l'aide d'au moins trois montants souples (7).

5. Un appareil de projection lithographique selon l'une quelconque des revendications précédentes, dans lequel le système de projection est monté de manière souple grâce à au moins un montant souple comprenant :
- un organe en forme de T (10), l'un d'entre le système de projection (PL) et le cadre de référence (5) étant attaché aux deux extrémités de la pièce transversale (11) et l'autre étant attaché à l'extrémité du pied (12).

6. Un appareil de projection lithographique selon la revendication 5, dans lequel l'organe en forme de T (10) a une première fréquence propre interne qui est supérieure à 1 000 Hz.

7. Un appareil de projection lithographique selon l'une quelconque des revendications précédentes, dans lequel le système de projection (PL) est monté de manière souple grâce à au moins un montant souple (7) qui est soit un montant pneumatique, soit un ressort, soit un support magnétique.

8. Un appareil de projection lithographique selon l'une quelconque des revendications précédentes, dans lequel le mouvement du système de projection (PL) relativement au cadre de référence (5) est amorti.

9. Un appareil de projection lithographique selon la revendication 8, dans lequel ledit amortissement est un amortissement actif contrôlé par des actionneurs piézoélectriques ou des actionneurs à force de Lorentz.

10. Un procédé de fabrication de dispositif comprenant les étapes consistant à :
- fournir un substrat (W) qui est au moins partiellement recouvert d'une couche de matériau sensible à un rayonnement ;
- fournir un faisceau de projection de rayonnement (PB) à l'aide d'un système de rayonnement (LA, Ex, IL) ;
- utiliser un moyen pour conformer selon un motif (MA) afin de doter le faisceau de projection (PB) d'un motif dans sa coupe transversale ;
- projeter le faisceau de rayonnement à motif sur une portion cible (C) de la couche de matériau sensible à un rayonnement à l'aide d'un système de projection (PL) ;
- supporter un cadre de référence (5), une structure formant support (MT) destinée à supporter le moyen pour conformer selon un motif (MA) et une table porte-substrat (WT) destinée à porter le substrat (W) sur une base ; ledit cadre de référence (5) étant monté de manière souple sur la base (BP) et ledit système de projection (PL) étant monté sur ledit cadre de référence (5) ;
- monter de manière souple le système de projection (PL) sur ledit cadre de référence (5) pendant la projection du faisceau de rayonnement à motif sur la portion cible (C) ;
**caractérisé par le fait que** :
ladite étape consistant à monter de manière souple le système de projection (PL) sur ledit cadre de référence (5) se fait sur au moins soit les axes nodaux (19, 20) du mode dominant de vibration de flexion du cadre de référence, soit les axes nodaux (16, 17) du mode dominant de vibration de torsion du cadre de référence.
